## Europäisches Patentamt

## European Patent Office

## Office européen des brevets

(11) Veröffentlichungsnummer: **0 211 318 B1**

## EUROPÄISCHE PATENTSCHRIFT

(45) Veröffentlichungstag der Patentschrift:
27.09.89

(21) Anmeldenummer: 86110076.6

(22) Anmeldetag: 22.07.86

(51) Int. Cl.⁴: **H01L 21/60**, H01L 23/52, H01L 21/31

(54) Verfahren zum selektiven Auffüllen von in Isolationsschichten geätzten Kontaktlöchern mit metallisch leitenden Materialien bei der Herstellung von höchstintegrierten Halbleiterschaltungen sowie eine Vorrichtung zur Durchführung des Verfahrens.

(30) Priorität: 29.07.85 DE 3527132

(43) Veröffentlichungstag der Anmeldung:
25.02.87 Patentblatt 87/9

(45) Bekanntmachung des Hinweises auf die Patenterteilung:
27.09.89 Patentblatt 89/39

(84) Benannte Vertragsstaaten:
AT CH DE FR GB IT LI NL

(56) Entgegenhaltungen:
EP-A- 0 090 319
US-A- 4 361 599

IBM TECHNICAL DISCLOSURE BULLETIN, Band 22, Nr. 11, April 1980, Seite 4964, New York, US; M. BRISKA et al.: "Method of producing Schottky contacts"
PATENTS ABSTRACTS OF JAPAN, Band 7, Nr. 123, 27. Mai 1983, Seite 99 E 178; & JP-A-58 42 227 (TOKYO SHIBAURA DENKI K.K.) 11.03.1983
SOLID STATE TECHNOLOGY, Band 24, Nr. 1, Januar 1981, Seiten 65-72,92, New York, US; F. MOHAMMADI: "Silicides for interconnection technology"

(73) Patentinhaber: Siemens Aktiengesellschaft,
Wittelsbacherplatz 2, D-8000 München 2(DE)

(72) Erfinder: Hieber, Konrad, Dr., Laubensteinstrasse 7, D-8214 Bernau(DE)
Erfinder: Stolz, Manfred, Dr.-W. v. Miller-Strasse 50, D-8000 München 83(DE)
Erfinder: Wieczorek, Claudia, Ostpreussenstrasse 2, D-8012 Ottobrunn(DE)

## Beschreibung

Die Erfindung betrifft ein Verfahren zum selektiven Auffüllen von in Isolationsschichten geätzten Kontaktlöchern oder via holes (das sind relativ kleine Löcher, die zwischen den Leitbahnebenen hergestellt werden) mit metallisch leitenden Materialien, wie sie insbesondere zur Herstellung von höchstintegrierten Halbleiterschaltungen zur Ausbildung von elektrischen Leitbahnen auf strukturierten Halbleitersubstraten erforderlich sind, sowie eine Vorrichtung zur Durchführung des Verfahrens.

Bei der fortschreitenden Miniaturisierung von Halbleiterbauelementen treten bereits Strukturen im Bereich von 1 µm und darunter auf. Um die sehr kleinen aktiven Bereiche auf dem Halbleitersubstrat elektrisch ansteuern zu können, müssen diese mit metallischen Leitbahnen verbunden werden. Damit dieser Kontakt nur an definierten Stellen stattfindet, ist die Leitbahn durch eine Isolationsschicht, zum Beispiel aus $SiO_2$ bestehend, vom Halbleitersubstrat getrennt. Die Verbindung zu den aktiven Bereichen des Halbleitersubstrats findet über Kontaktlöcher statt, die in die Isolationsschicht eingeätzt werden.

Analoge Verhältnisse herrschen auch bei höchstintegrierten Halbleiterschaltungen, bei denen zwei und mehr Leitbahnebenen für die elektrische Versorgung der sehr dicht gepackten aktiven Bereiche notwendig sind. Auch in diesem Fall muß ein elektrischer Kontakt durch sehr kleine Löcher (via holes) zwischen den verschiedenen Leitbahnebenen hergestellt werden.

Da aufgrund von schaltungstechnischen Überlegungen (zum Beispiel parasitäre Kapazitäten) die Isolationsschicht eine Mindestdicke von 0,7 bis 1,5 µm besitzen muß, treten bei den Kontaktlöchern bzw. via holes Tiefen/Durchmesserverhältnisse von größer/gleich 1 auf. Bei diesen sehr kleinen und tiefen Kontaktlöchern nimmt die Schichtdicke der Leitbahnen an den Flanken des Kontaktloches sehr stark ab (55 bis 80 % Abnahme), wenn das Leitbahnmaterial, zum Beispiel Aluminiumlegierungen : Aluminium-Silizium- (1 %), wie bisher üblich durch Kathodenzerstäubung (Sputtern) aufgebracht wird. Da die Leitbahnen mit extrem hohen Stromdichten belastet sind (zum Beispiel $1 \times 10^6$ A/cm²), bewirkt jede Querschnittsverengung einen lokalen Temperaturanstieg, der an den Grenzflächen zwischen den verschiedenen Materialien im Kontakt einen unerwünschten Materialtransport (Diffusion, Reaktion) beschleunigt. Dies kann auch bis zum Durchbrennen einer Leitbahn führen.

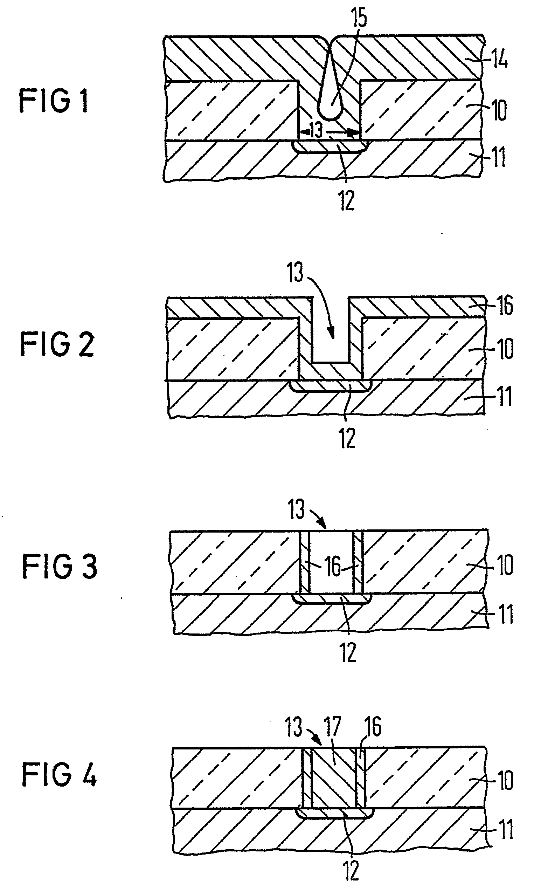

Ein weiteres Problem besteht darin, wie aus der Figur 1 zu ersehen ist, daß sich in den Kontaktlöchern nach der Beschichtung zum Beispiel mit Aluminium-Silizium Hohlräume (15) ausbilden können. Wird nun daran anschließend eine Isolationsschicht, zum Beispiel als Unterlage für eine weitere Aluminium-Silizium-Leitbahnebene abgeschieden, so ist es praktisch nicht möglich, den im Kontaktloch befindlichen Hohlraum vollständig aufzufüllen. Da sich bei weiteren Fertigungsschritten in diesem Hohlraum zum Teil reaktive oder korrosive Medien ansammeln können, ist es für zuverlässige Bauelemente notwendig, ein Kontaktloch- bzw. via hole-Metallisierungsverfahren anzugeben, bei dem eine vollständige Auffüllung stattfindet.

Aus dem Stand der Technik sind zum Auffüllen von Kontaktlöchern CVD (= chemical vapor deposition)-Verfahren bekannt, die sich durch eine sehr gute Kantenbedeckung auszeichnen. Es werden zwei verschiedene Methoden unterschieden:

1. Die ganzflächige Abscheidung der Metallisierungsschicht auf der Isolationsschicht einschließlich der Kontaktlöcher, unter Verwendung von Wolfram, wie sie aus einem Aufsatz von D. L. Brors et. al. aus Solid State Technol. April (1984), Seiten 313 bis 314, bekannt ist. Aufgrund der guten Kantenbedeckung des CVD-Verfahrens wächst die Schicht im Kontaktloch von allen Seiten etwa gleich schnell und füllt somit das Kontaktloch auf. Dieser Zustand ist bei einer Schichtdicke (gemessen auf horizontaler Struktur), die etwas mehr als der Hälfte des Kontaktlochdurchmessers entspricht, eingetreten. Ätzt man nun die Metallschicht wieder ganzflächig ab, so kann erreicht werden, daß das Metall von der Isolationsschicht vollständig entfernt ist, während das Kontaktloch noch mit Metall gefüllt bleibt.

2. Die selektive Abscheidung der Metallisierungsschicht in Kontaktlöchern unter Verwendung von Wolfram oder Tantalsilizid als Kontaktlochfüller, wie sie zum Beispiel für Wolfram aus einem Aufsatz von E. K. Broadbent et. al. in J. Electrochem. Soc., Solid State Sci. and Technol. (1984), Seiten 1427 bis 1433 oder für Tantalsilizid aus der Europäischen Patentanmeldung 0 090 319 bekannt ist. Bei den genannten CVD-Verfahren wird der Beschichtungsprozeß derart eingestellt, daß die chemische Reaktion, die die Beschichtung bewirkt, durch eine vorangehende Reaktion mit einem bestimmten Substratmaterial, zum Beispiel mit Silizium oder einer Siliziumlegierung, lokal ausgelöst werden kann. Es kann somit erreicht werden, daß das Kontaktloch voll ständig mit "Metall" aufgefüllt wird. So kann Wolfram bei Temperaturen um 360°C bis zu 1 µm Schichtdicke selektiv auf Silizium bzw. einer Siliziumlegierung abgeschieden werden. Aufgrund der die Selektivität auslösenden Reaktion ($2\ WF_6 + 3\ Si \rightarrow 3\ SiF_4 + 2\ W$) wird jedoch Silizium angeätzt ($SiF_4$ besitzt einen hohen Dampfdruck), was zu Kurzschlüssen zwischen dem Dotierungsgebiet und dem Substrat führt.

Eine weitere Schwierigkeit bei diesem Verfahren besteht darin, daß zwischen dem selektiv aufwachsenden Metall und den aus $SiO_2$ bestehenden Seitenwänden des Kontaktloches nur eine schlechte Bindung besteht, so daß es hier lokal zu Haftungsproblemen und damit auch zu Hohlraumbildungen kommen kann.

Das größte Problem bei einer selektiven Abscheidung besteht jedoch darin, daß die natürliche Oxidhaut in situ auf dem zu beschichtenden Silizium bzw. auf der Siliziumlegierung entfernt werden muß. Diese Maßnahme ist unbedingt erforderlich, um bei der Beschichtung eine ausreichende Selektivität gegenüber der $SiO_2$-Isolationsschicht zu erreichen.

Bei der selektiven Wolfram-Abscheidung bewirkt das Wolframhexafluorid bereits die Ätzung der ca. 3 nm dicken natürlichen Oxidhaut. Jedoch ist dieser Ätzschritt, der eine Nebenerscheinung des Beschichtungsprozesses darstellt, nur schwer zu steuern.

Die selektive Tantalsilizid-Abscheidung mit Tantalpentachlorid als Metallausgangsverbindung bietet die Möglichkeit, vor der Beschichtung in situ einen eigenen Ätzschritt durchzuführen. Auch hier zeigt sich, daß ein definiertes Ätzen der natürlichen Oxidhaut (zum Beispiel mit Fluorwasserstoff) sehr schwierig ist. Vor allem gibt es keine Möglichkeit der Endpunktkontrolle, da die natürliche Oxidhaut sehr dünn ist und die Summe aller Kontaktlochflächen sehr klein ist im Vergleich zur $SiO_2$-Isolationsschichtfläche.

Aufgabe der Erfindung ist es daher, ein Verfahren anzugeben, mit dem es möglich ist, in VLSI-Strukturen in sehr kleinen Kontaktlöchern und/oder via holes, die auf dem Silizium vorhandene Oxidhaut zu ätzen und daran anschließend die Kontaktlöcher und/oder via holes mit metallisch leitendem Material zu füllen, ohne daß Hohlräume an den Kontaktlochwänden entstehen können. Es ist weiterhin Aufgabe der Erfindung, eine Vorrichtung zur Durchführung dieses Verfahrens anzugeben.

Diese Aufgabe wird durch ein Verfahren gelöst, welches durch den Ablauf folgender Verfahrensschritte gekennzeichnet ist:

a) ganzflächige Beschichtung der strukturierten, mit den Kontaktlöchern und/oder via holes versehenen Halbleitersubstrate mit einem Silizid eines hochschmelzenden Metalls durch eine chemische Abscheidung aus der Gasphase,
b) anisotropes Ätzen der Substrate im Vakuum bis die Silizidschicht an den horizontalen Flächen des Substrats wieder entfernt ist und
c) Auffüllen der Kontaktlöcher und/oder via holes mit dem metallisch leitenden Material durch selektive chemische Abscheidung aus der Gasphase.

Weitere Ausgestaltungen der Erfindung ergeben sich aus den Unteransprüchen.

Durch dieses im wesentlichen dreistufige Verfahren ergeben sich folgende Vorteile:
Nach der ganzflächigen Beschichtung mit einem Silizid eines hochschmelzenden Metalles nach Verfahrensschritt a), welche so lange durchgeführt wird, bis eine ca. 100 nm dicke Schicht an den Kontaktlochwänden entstanden ist, wird ein anisotroper Ätzprozeß durchgeführt. Dieser zeichnet sich dadurch aus, daß die Ätzrate für das vorher abgeschiedene Silizid an den horizontalen Flächen wesentlich höher ist als den vertikalen Flächen. Damit wird erreicht, daß das Silizid von den horizontalen Flächen vollständig entfernt werden kann, während an den vertikalen Kontaktlochwänden noch eine zusammenhängende Silizidschicht bestehen bleibt. Dieser Ätzschritt besitzt noch den weiteren Vorteil einer guten Endpunktkontrolle, da der horizontale Flächenanteil auf dem Substrat wesentlich größer ist als der vertikale. Ferner ist eine gewisse Überätzung des Silizids sogar notwendig, da hierbei auch die natürlich Oxidhaut beseitigt wird.

Wesentlich ist nun, daß die so behandelten Scheiben nach dem Ätzen nicht an Luft gelangen, sondern ohne Unterbrechung des Vakuums selektiv mit zum Beispiel Molybdän, Molybdänsilizid, Wolfram, Wolframsilizid, Tantalsilizid, Titansilizid oder Niobsilizid beschichtet werden. Da sich nun keine Oxidhaut mehr auf dem Kontaktlochboden befindet, bildet sich sehr schnell eine zusammenhängende, dichte Metall- bzw. Silizidschicht, die auch gut an den mit Silizid vorbeschichteten Kontaktlochwänden haftet.

Im folgenden wird anhand von zwei Ausführungsbeispielen und der Figuren 1 bis 5 die Erfindung noch näher erläutert. Dabei zeigen:

die Figur 1 schematisch im Schnittbild eine Kontaktlochauffüllung durch Sputtern, wie sie aus dem Stand der Technik bekannt ist,
die Figuren 2 bis 4 im Schnittbild die erfindungswesentlichen Verfahrensschritte zur Kontaktloch- bzw. via hole-Auffüllung und
die Figur 5 schematisch eine aus fünf Vakuumkammern bestehende Einscheiben-Durchlaufanlage, wie sie mit Vorteil für das erfindungsgemäße Verfahren verwendet wird.

Figur 1: Mit dem Bezugszeichen 10 ist die auf dem Siliziumsubstrat 11 mit der dotierten Zone 12 befindliche $SiO_2$-Schicht bezeichnet, welche das ca. 1 µm tiefe und 1 µm breite Kontaktloch 13 enthält. Das Kontaktloch 13 wurde mit einer aus einer Aluminium-Silizium-Legierung bestehenden, elektrisch leitenden Materialschicht 14 durch Sputtern aufgefüllt. Mit 15 ist der im Kontaktloch 13 entstandene Hohlraum (Kaverne) bezeichnet, der durch das Verfahren nach der Lehre der Erfindung sicher vermieden werden kann.

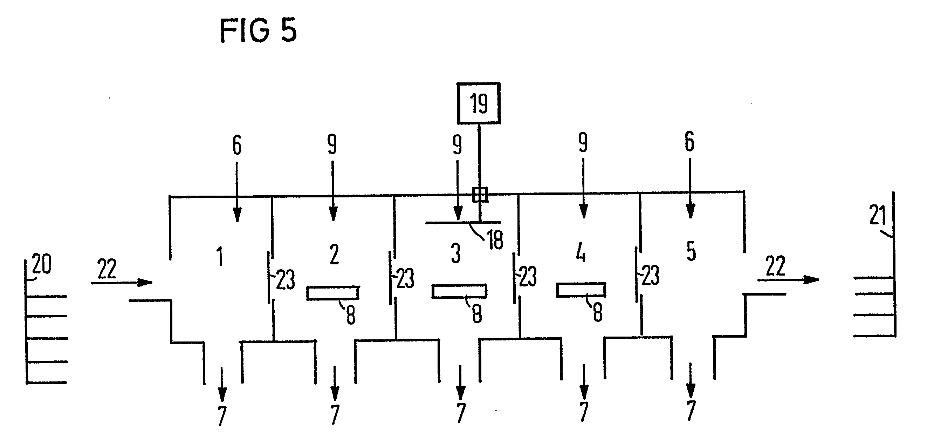

Die Figur 2 zeigt den ersten Schritt des erfindungsgemäßen Verfahrens am Beispiel einer ganzflächigen LPCVD-(= low pressure chemical vapor deposition)-Abscheidung von Tantalsilizid 16 für ein, in eine $SiO_2$-Schicht 10 geätztes Kontaktloch 13 (oder von Wolframsilizid für ein via hole) auf ein mit einer dotierten Zone 12 versehenes Halbleitersubstrat 11. Die Abscheidung wird solange fortgesetzt bis an den Kontaktlochwänden ca. 100 nm Silizid abgeschieden ist. Die Verfahrensparameter werden bei der Beschreibung der Figur 5 näher erläutert.

Figur 3: Die mit der Tantalsilizid- oder Wolframsilizid-Schicht (16) ganzflächig bedeckten Silizium-Substratscheiben 10, 11, 12 werden in einem anisotropen Ätzschritt einem halogenhaltigen Plasma unterworfen und das Tantalsilizid (oder Wolframsilizid) an den horizontalen Flächen der Anordnung entfernt. Bedeckt mit dem Tantalsilizid 16 bleiben nur die Seitenwände des Kontaktlochs 13.

Figur 4 zeigt die Anordnung nach dem Wiederauffüllen des Kontaktloches 13 durch selektive Abscheidung vom Tantalsilizid 17 aus der Gasphase. Dabei werden die Prozeßparameter so eingestellt, daß sich Tantalsilizid nur auf den Silizium- bzw. Tantalsilizid-Flächen abscheidet (siehe auch europäische Patentanmeldung 0 090 319).

Figur 5:

1. Ausführungsbeispiel:

Die Durchlaufanlage wird zunächst am Beispiel des Auffüllens von Kontaktlöchern mit Tantalsilizid beschrieben.

Über eine Vakuumschleuse 1 mit einem Klappventil 23 wird die 150 mm große strukturierte Siliziumscheibe (in den Figuren 2 bis 4 mit 10, 11, 12 bezeichnet, in Figur 5 nicht dargestellt) aus dem Transportbehälter 20 automatisch in die eigentliche Beschichtungskammer 2 eingeschleust (23), wo sie zunächst rasch auf einem Heiztisch 8 auf 650°C erhitzt wird. Zur ganzflächigen Tantalsilizid-Abscheidung wird eine Gasmischung aus Silan, Wasserstoff und Tantalpentachlorid verwendet (zum Beispiel Silan: 20 ml/min, Wasserstoff: 100 bis 400 ml/min, Tantalpentachlorid-Partialdruck: ca. $2 \times 10^{-1}$ mbar). Der Gesamtdruck während der Beschichtung liegt vorzugsweise im Bereich von 150 bis 200 µbar, wobei sich eine Abscheiderate von ca. 20 bis 70 nm/min Tantalsilizid ergibt.

Nach zum Beispiel 1,5 Minuten wird (entsprechend ca. 100 nm Schichtdicke) nun die mit Tantalsilizid ganzflächig beschichtete Substratscheibe aus der Kammer 2 über ein weiteres Klappventil 23 in eine zweite Reaktionskammer 3 transportiert, wo nun der anisotrope Ätzschritt durchgeführt wird, der zum Beispiel aus Plasmaätzen in einer Bortrichlorid/Chlor-Atmosphäre bei einem Gesamtdruck von zum Beispiel 30 µbar besteht. Die Substrattemperatur be trägt maximal 650°C. Elektrode mit Hochfrequenzgenerator sind mit 18 und 19 gekennzeichnet.

Nach Beendigung des Ätzschrittes in der Kammer 3 wird die Siliziumkristallscheibe über ein weiteres Klappventil 23 in eine vierte (4) oder wieder in die zweite Vakuumkammer (2) transportiert, wo nun die eigentliche Kontaktlochauffüllung durch selektive Abscheidung von Tantalsilizid stattfindet. Hierzu wird ein Gasgemisch aus Silan, Wasserstoff, Tantalpentachlorid und Chlorwasserstoff oder Dichlorsilan, Wasserstoff und Tantalpentachlorid verwendet (Dichlorsilan: 20 ml/min, Wasserstoff: 1000 ml/min, Tantalpentachlorid-Partialdruck: ca. 200 µbar). Die Beschichtungstemperatur (Heiztisch 8) für die selektive Abscheidung beträgt unter den gewählten Bedingungen ebenfalls 650°C. Es lassen sich dabei bis zu 1 µm tiefe Kontaktlöcher mit einer Rate von ca. 30 nm/min auffüllen. Der Gesamtdruck liegt zum Beispiel bei 550 µbar.

Nach Abschluß der selektiven Beschichtung wird die Siliziumscheibe automatisch über eine Schleuse 5 bzw. 1 aus der Beschichtungskammer 4 bzw. 2 transportiert und in einem Transportbehälter 21 bzw. 20 deponiert.

Es ist offensichtlich, daß eine CVD-Anlage mit drei Vakuumkammern (2, 3, 4) einen höheren Durchsatz bietet als eine aus zwei Kammern, da während der selektiven Beschichtung in der Kammer 4 bereits eine weitere Siliziumsubstratscheibe in der Kammer 2 ganzflächig mit Tantalsilizid belegt werden kann.

Mit dem Bezugszeichen 6 sind Gaseinlässe für Belüftungsgase, mit 7 Anschlüsse für einen Hochvakuumpumpstand und mit 9 Gaseinlaßsysteme für die jeweiligen Reaktionsgase bezeichnet.

2. Ausführungsbeispiel:

Auffüllen von via holes mit Wolfram.

Analog zur Tantalsilizidabscheidung wird zunächst in der Vakuumkammer 2 ganzflächig eine Wolframsilizid-Schicht bei zum Beispiel 360°C (Tisch 8) abgeschieden, wobei Wolframhexafluorid als Wolfram-Verbindung verwendet wird (Wolframhexafluorid: 10 ml/min, Silan: 1000 ml/min, Inertgas zum Beispiel Helium: 200 ml/min, Gesamtdruck ca. 300 µbar, Abscheiderate ca. 30 nm/min; nähere Einzelheiten über die Abscheidung sind aus einem Aufsatz von D. L. Brors et. al. in "Semiconductor International", Mai 1984, Seiten 82 bis 85, zu entnehmen).

Anschließend wird das Wolframsilizid in der Kammer 3 anisotrop im Plasma (18, 19) geätzt, zum Beispiel in Schwefelhexafluorid bei einem Gesamtdruck von 330 µbar.

Für die selektive Wolfram-Abscheidung wird in Kammer 4 Wolframhexafluorid (100 ml/min) verwendet. Nachdem sich eine geschlossene Wolframschicht durch Reduktion des Wolframhexafluorids durch Silizium gebildet hat, wird Wasserstoffgas zusätzlich beigemischt, so daß jetzt Wolfram durch Wasserstoffreduktion des Wolframhexafluorid gebildet wird. Dabei werden wieder ca. 100 ml/min Wolframhexafluorid mit zusätzlich 1000 ml/min Wasserstoff verwendet. Die Abscheiderate beträgt ca. 30 nm/min, der Gesamtdruck ca. 250 µbar.

Aufgrund der wesentlich höheren Keimbildungsgeschwindigkeit von Wolfram auf Wolfram im Vergleich zu Wolfram auf $SiO_2$ kann eine selektive Wolfram-Abscheidung bis zu 1 µm Dicke erreicht werden, ohne daß sich auch auf dem Oxid Wolfram-Keime bilden.

Die selektive Molybdän-Abscheidung verläuft analog zur Wolfram-Abscheidung, wobei Molybdänpentafluorid als Aus gangssubstanz verwendet wird.

Für die selektive Abscheidung von Wolframsilizid, Molybdänsilizid, Niobsilizid oder Titansilizid werden Wolframhexafluorid, Molybdänpentafluorid, Niobpentachlorid oder Titantetrachlorid zusammen mit Dichlorsilan und Wasserstoff analog zur selektiven Tantalsilizid-Abscheidung zur Reaktion gebracht.

**Patentansprüche**

1. Verfahren zum selektiven Auffüllen von in Isolationsschichten geätzten Kontaktlöchern oder via holes mit metallisch leitenden Materialien, wie sie insbesondere zur Herstellung von höchstintegrierten Halbleiterschaltungen zur Ausbildung von elektrischen Leitbahnen auf strukturierten Halbleitersubstraten erforderlich sind, **gekennzeichnet durch** den Ablauf folgender Verfahrensschritte:
    a) ganzflächige Beschichtung der strukturierten, mit den Kontaktlöchern (13) und/oder via holes versehenen Halbleitersubstrate (11, 12) mit einem Silizid (16) eines hochschmelzenden Metalls durch chemische Abscheidung aus der Gasphase,

b) anisotropes Ätzen der Substrate (10, 11, 12) im Vakuum bis die Silizidschicht (16) an den horizontalen Flächen des Substrats (10, 11) wieder entfernt ist, und

c) Auffüllen der Kontaktlöcher (13) und/oder via holes mit dem metallisch leitenden Material (17) durch selektive chemische Abscheidung aus der Gasphase.

2. Verfahren nach Anspruch 1, **dadurch gekennzeichnet**, daß als Silizide (16, 17) die Silizide der Metalle Wolfram, Molybdän, Niob, Tantal und Titan verwendet werden.

3. Verfahren nach Anspruch 1 und 2, **dadurch gekennzeichnet**, daß als metallisch leitende Materialien (17) die Metalle Tantal, Wolfram, Molybdän, Niob und Titan oder deren Silizide verwendet werden.

4. Verfahren nach mindestens einem der Ansprüche 1 bis 3, **dadurch gekennzeichnet**, daß das anisotrope Ätzen durch Plasmaätzen in einer Bortrichlorid/Chlor-Atmosphäre in einem Druckbereich von 25 - 35 μbar oder in einer Schwefelhexafluorid-Atmosphäre in einem Druckbereich von 250 - 400 μbar vorgenommen wird.

5. Verfahren nach mindestens einem der Ansprüche 1 bis 4, **dadurch gekennzeichnet**, daß für die chemische Abscheidung (16, 17) aus der Gasphase die Halogenide der Metalle und Silane bzw. deren Halogenverbindungen verwendet werden und die Abscheidung bei vermindertem Druck durchgeführt wird.

6. Verfahren nach mindestens einem der Ansprüche 1 bis 5, **dadurch gekennzeichnet**, daß bei der selektiven chemischen Abscheidung (17) aus der Gasphase Druck, Abscheidetemperatur und die Zusammensetzung des Reaktionsgases auf Werte eingestellt werden, bei denen durch die Anwesenheit des Halogenwasserstoffs eine Keimbildung auf den, vorzugsweise aus SiO$_2$ bestehenden Isolationsschichtbereichen (10) unterdrückt wird.

7. Verfahren nach mindestens einem der Ansprüche 1 bis 6, **dadurch gekennzeichnet**, daß bei der selektiven Abscheidung (17) von Tantalsilizid ein Gasgemisch, bestehend aus Dichlorsilan (SiH$_2$Cl$_2$), Wasserstoff und Tantalpentachlorid (TaCl$_5$) verwendet wird, der Tantalpentachlorid-Partialdruck auf ca. 200 μbar der Gesamtdruck im Bereich von 400 bis 600 μbar und die Beschichtungstemperatur auf 650°C eingestellt wird.

8. Verfahren nach mindestens einem der Ansprüche 1 bis 6, **dadurch gekennzeichnet**, daß bei der selektiven Abscheidung (17) von Wolfram ein Gasgemisch, bestehend aus Wolframhexafluorid (WF$_6$) und Wasserstoff im Verhältnis 1 : 10 verwendet wird, der Druck auf ca. 250 μbar eingestellt wird und die Beschichtungstem peratur auf ca. 400°C gehalten wird.

9. Verfahren nach mindestens einem der Ansprüche 1 bis 8, **dadurch gekennzeichnet**, daß die Schichtdicke bei der ganzflächigen Abscheidung (16) so eingestellt wird, daß an den Kontaktlochwänden (13) eine Schichtdicke von ca. 100 nm entsteht.

10. Verfahren nach mindestens einem der Ansprüche 1 bis 9, **dadurch gekennzeichnet**, daß die strukturierten Substrate (10, 11, 12) vor der Beschichtung einer Oberflächenbehandlung durch Eintauchen in verdünnte Flußsäure unterzogen werden.

11. Vorrichtung zur Durchführung des Verfahrens nach mindestens einem der Ansprüche 1 bis 10, **dadurch gekennzeichnet**, daß

a) fünf, hintereinander geschaltete, durch Klappenventile (23) getrennte Kammern (1, 2, 3, 4, 5) mit je einem Anschluß (7) für einen Hochvakuumpumpstand vorgesehen sind, von denen die erste (1) und fünfte Vakuumkammer (5) mit je einem Gaseinlaßsystem (6) für Belüftungsgase versehen ist und als Vakuumschleuse dient,

b) die zweite, dritte und vierte Kammer je einen beheizbaren Tisch (8) für die Aufnahme der Substratscheiben und je ein Gaseinlaßsystem (9) für die Reaktionsgase enthalten und

c) die dritte Vakuumkammer (3) über eine Elektrode (18) mit einem Hochfrequenzgenerator (19) verbunden ist.

12. Vorrichtung nach Anspruch 11, **dadurch gekennzeichnet**, daß Transportbehälter (20, 21) vor der ersten und nach der fünften Vakuumkammer vorgesehen sind, aus denen bzw. in die automatisch die strukturierten bzw. beschichteten Substratscheiben in die Schleuse (1) bzw. aus der Schleuse (5) gelangen.

**Claims**

1. Process for selectively filling contact holes or through holes made by etching in insulating layers with metallically conductive materials such as are used, in particular, for the manufacture of high-density integrated semiconductor circuits, for forming electric conductor tracks on structured semiconductor substrates, characterized by the sequence of the following process steps:

a) coating of the structured semiconductor substrates (11, 12), provided with the contact holes (13) and/or through holes, over the entire surface with a silicide (16) of a high-melting metal by chemical deposition from the gas phase,

b) anisotropic etching of the substrate (10, 11, 12) in a vacuum until the silicide layer (16) at the horizontal surfaces of the substrate (10, 11) is removed again, and

c) filling the contact holes (13) and/or through holes with the metallically conductive material (17) by selective chemical deposition from the gas phase.

2. Process according to Claim 1, characterized in that the silicides of the metals tungsten, molybdenum, niobium, tantalum and titanium are used as silicides (16, 17).

3. Process according to Claim 1 and 2, characterized in that the metals tantalum, tungsten, molybdenum, 3, characterized in that the anisotropic etching is performed by plasmaetching in a boron trichloride/chlorine atmosphere in a pressure range of 25–35 μbar or in a sulphurhexafluoride atmosphere in a pressure range of 250–400 μbar.

5. Process according to at least one of Claims 1 to 4, characterized in that the halogenides of the metals and silanes or their halogen compounds are used for the chemical deposition (16, 17) from the gas phase and the deposition is carried out at reduced pressure.

6. Process according to at least one of Claims 1 to 5, characterized in that in the selective chemical deposition (17) from the gas phase, pressure, deposition temperature and the composition of the reaction gas are set to values at which a nucleation on the isolation layer regions (10) preferably consisting of $SiO_2$ is suppressed due to the presence of the halogen halide.

7. Process according to at least one of Claims 1 to 6, characterized in that a gas mixture consisting of dichlorosilane ($SiH_2Cl_2$), hydrogen and tantalum pentachloride ($TaCl_5$) is used in the selective deposition (17) of tantalum silicide, the tantalum pentachloride partial pressure is set to approx. 200 µbar, the total pressure in the range of 400 to 600 µbar and the coating temperature to 650°c.

8. Process according to at least one of Claims 1 to 6, characterized in that a gas mixture consisting of tungsten hexafluoride ($WF_6$) and hydrogen is used in a ratio of 1:10 in the selective deposition (17) of tungsten, pressure is set to approx. 250 µbar and the coating temperature is kept at approx. 400°C.

9. Process according to at least one of Claims 1 to 8, characterized in that the layer thickness in the deposition (16) over the entire surface is adjusted in such a manner that a layer thickness of approx. 100 nm is produced at the contact hole walls (13).

10. Process according to at least one of Claims 1 to 9, characterized in that the structured substrates (10, 11, 12) are subjected to a surface treatment immersion in diluted hydrofluoric acid before the coating.

11. Device for carrying out the process according to at least one of Claims 1 to 10, characterized in that

a) five series-connected chambers (1, 2, 3, 4, 5), which are separated by flap valves (23) are provided with one connection (7) each for a high vacuum pumping station, of which the first (1) and fifth vacuum chamber (5) is provided with one gas inlet system (6) each for venting gases and is used as vacuum lock,

b) the second, third and fourth chamber each contain a heatable bench (8) for receiving the substrate discs and one gas inlet system (9) each for the reaction gases and

c) the third vacuum chamber (3) is connected to a high-frequency generator (19) via an electrode (18).

12. Device according to Claim 11, characterized in that transport containers (20, 21) are provided in front of the first and following the fifth vacuum chamber, from which or into which the structured or coated substrate discs automatically pass into the lock (1) or out of the lock (5), respectively.

**Revendications**

1. Procédé pour le remplissage sélectif avec des matériaux à conduction métallique de trous de contact ou de trous d'interconnexion entre couches ou "via holes", gravés dans des couches isolantes, comme ceux qui sont nécessaires en particulier pour fabriquer des circuits à semi-conducteurs à très haut degré d'intégration, en vue de la formation de pistes conductives électriques sur des substrats semiconducteurs structurés, caractérisé par la suite des opérations suivantes:

a) revêtement de toute la surface des substrats semi-conducteurs (11, 12) structurés, pourvus des trous de contact (13) et/ou des trous d'interconnexion, avec un siliciure (16) d'un métal à haut point de fusion par dépôt chimique à partir de la phase gazeuse,

b) gravure anisotrope des substrats (10, 11, 12) dans le vide, jusqu'à ce que la couche de siliciure (16) soit enlevée de nouveau des surfaces horizontales du substrat (10, 11) et c) remplissage des trous de contact (13) et/ou des trous d'interconnexion avec le matériau à conduction métallique (17) par dépôt chimique sélectif à partir de la phase gazeuse.

2. Procédé selon la revendication 1, caractérisé en ce que l'on utilise, en tant que siliciures (16, 17), les siliciures des métaux suivants: tungstène, molybdène, niobium, tantale et titane.

3. Procédé selon les revendications 1 et 2, caractérisé en ce que l'on utilise, en tant que matériaux (17) à conduction métallique, les métaux suivants: tantale, tungstène, molybdène, niobium et titane ou leurs siliciures.

4. Procédé selon au moins une des revendications 1 à 3, caractérisé en ce que l'on effectue la gravure anisotrope par gravure au plasma dans une atmosphère de trichlorure de bore/chlore dans une plage de pression de 25–35 µbar ou dans une atmosphère d'hexafluorure de soufre dans une plage de pression de 250–400 µbar.

5. Procédé selon au moins une des revendications 1 à 4, caractérisé en ce que, pour le dépôt chimique (16, 17) à partir de la phase gazeuse, on utilise les halogénures des métaux et des silanes ou leurs composés halogénés et on effectue le dépôt à pression réduite.

6. Procédé selon au moins une des revendications 1 à 5, caractérisé en ce que, lors du dépôt chimique sélectif (17) à partir de la phase gazeuse, on ajuste la pression, la température de dépôt et la composition du gaz réactionnel à des valeurs auxquelles, en raison de la présence de l'hydrogène halogéné, la germination sur les zones de couche isolante (10), de préférence en $SiO_2$, est supprimée.

7. Procédé selon au moins une des revendications 1 à 6, caractérise en ce que, lors du dépôt sélectif (17) de siliciure de tantale, l'on utilise un mélange gazeux formé de dichlorosilane ($SiH_2Cl_2$), hydrogène et pentachlorure de tantale ($TaCl_5$) et on ajuste la pression partielle du pentachlorure de tantale à environ 200 µbar, la pression totale entre 400 et 600 µbar et la température de revêtement à 650°C.

8. Procédé selon au moins une des revendications 1 à 6, caractérisé en ce que, lors du dépôt sélectif (17) de tungstène, on utilise un mélange gazeux formé d'hexafluorure de tungstène ($WF_6$) et d'hydrogène suivant le rapport 1:10, on ajuste la pression à environ 250 µbar et on maintient la température de revêtement à environ 400°C.

9. Procédé selon au moins une des revendications 1 à 8, caractérisé en ce que l'on ajuste l'épaisseur de couche, lors du dépôt sur toute la surface (16), de manière qu'une épaisseur de couche d'environ 100 nm se forme sur les parois des trous de contact (13).

10. Procédé selon au moins l'une des revendications 1 à 9, caractérisé en ce que, avant le revêtement, on soumet les substrats structurés (10, 11, 12) à un traitement superficiel par immersion dans l'acide fluorhydrique dilué.

11. Dispositif pour la mise en œuvre du procédé selon au moins une des revendications 1 à 10, caractérisé en ce que

a) il comprend cinq chambres (1, 2, 3, 4, 5) disposées les unes à la suite des autres et séparées par des vannes à clapet (23), chaque chambre présentant un raccordement (7) pour un groupe de pompages à vide poussé et les première (1) et cinquième (5) chambres à vide étant chacune pourvues d'un système d'admission de gaz (6) pour des gaz de ventilation et servant de sas à vide,

b) les deuxième, troisième et quatrième chambres contiennent chacune une table (8) pouvant être chauffée pour la réception des rondelles de substrat, de même qu'un système d'admission de gaz (9) pour les gaz réactionnels, et

c) la troisième chambre à vide (3) est connectée par une électrode (18) à un générateur de haute fréquence (19).

12. Dispositif selon la revendication 11, caractérisé en ce que des récipients de transport (20, 21) sont prévus avant la première et après la cinquième chambre à vide, récipients à partir desquels les rondelles de substrat structurées parviennent automatiquement dans un sas (1) ou dans lesquels les rondelles de substrat revêtues parviennent automatiquement à partir d'un sas (5).

FIG 1

FIG 2

FIG 3

FIG 4

# FIG 5

EP 0 211 318 B1